## Europäisches Patentamt
## European Patent Office
## Office européen des brevets

(19)

(11) Veröffentlichungsnummer: **0 006 459**
**B1**

(12) **EUROPÄISCHE PATENTSCHRIFT**

(45) Veröffentlichungstag der Patentschrift: **09.06.82**

(21) Anmeldenummer: **79101647.0**

(22) Anmeldetag: **29.05.79**

(51) Int. Cl.³: **C 25 D 1/10, C 25 D 1/08, C 23 F 1/08, G 03 F 7/20**

(54) **Anwendung der Galvanoplastik zur Herstellung von Präzisionsflachteilen.**

(30) Priorität: **29.06.78 DE 2828625**

(43) Veröffentlichungstag der Anmeldung:
**09.01.80 Patentblatt 80/1**

(45) Bekanntmachung des Hinweises auf die Patenterteilung:
**09.06.82 Patentblatt 82/23**

(84) Benannte Vertragsstaaten:
**BE FR GB IT NL**

(56) Entgegenhaltungen:
**FR - A - 2 356 975**
**US - A - 3 703 450**
**US - A - 3 900 359**

(73) Patentinhaber: **SIEMENS AKTIENGESELLSCHAFT**
**Berlin und München**
**Postfach 22 02 61**
**D-8000 München 22 (DE)**

(72) Erfinder: **Trausch, Günter-Elmar, Dipl.-Ing.**
**Feldafinger Strasse 39b**
**D-8000 München 71 (DE)**

Courier Press, Leamington Spa, England.

## Anwendung der Galvanoplastik zur Herstellung von Präzisionsflachteilen

Die Erfindung betrifft ein Verfahren zur Herstellung von Präzisionsflachteilen, wie Masken, Schablonen, Blenden, Düsenplatten mit kleinsten Fensteröffnungen und Konturendetails bei großer Materialstärke sowie hohen Anforderungen an Konturenausformung und Konstanz der Abmessungen mit beliebig ausformbarer Flankenform.

Flachteile mit den beschriebenen Eigenschaften lassen sich ätztechnisch oder auf andere Weise oft nicht mehr herstellen. Man bedient sich dann des Galvanoplastikverfahrens, das im Prinzip wie folgt arbeitet:

a) Fotolithographische Erzeugung einer Fotoresiststruktur auf einem metallischen Hilfsträger, mit der die Konturen des Flachteiles festgelegt werden.

b) Abformen dieser Struktur durch galvanische Metallabscheidung auf dem Träger.

c) Ablösen des Galvanos vom Träger oder chemisches Auflösen des Trägers.

d) Ablösen des Fotoresists von der Galvanoplastik.

Die Feinheit der Details eines Flachteiles wird begrenzt durch das Auflösevermögen des Fotoresists (Fotolack oder Fotofolie). Die Stärke des Flachteiles ist begrenzt durch die Resiststärke, wobei Resiststärke und Resistauflösung so korrelieren, daß zunehmende Stärke abnehmende Auflösung bedingt.

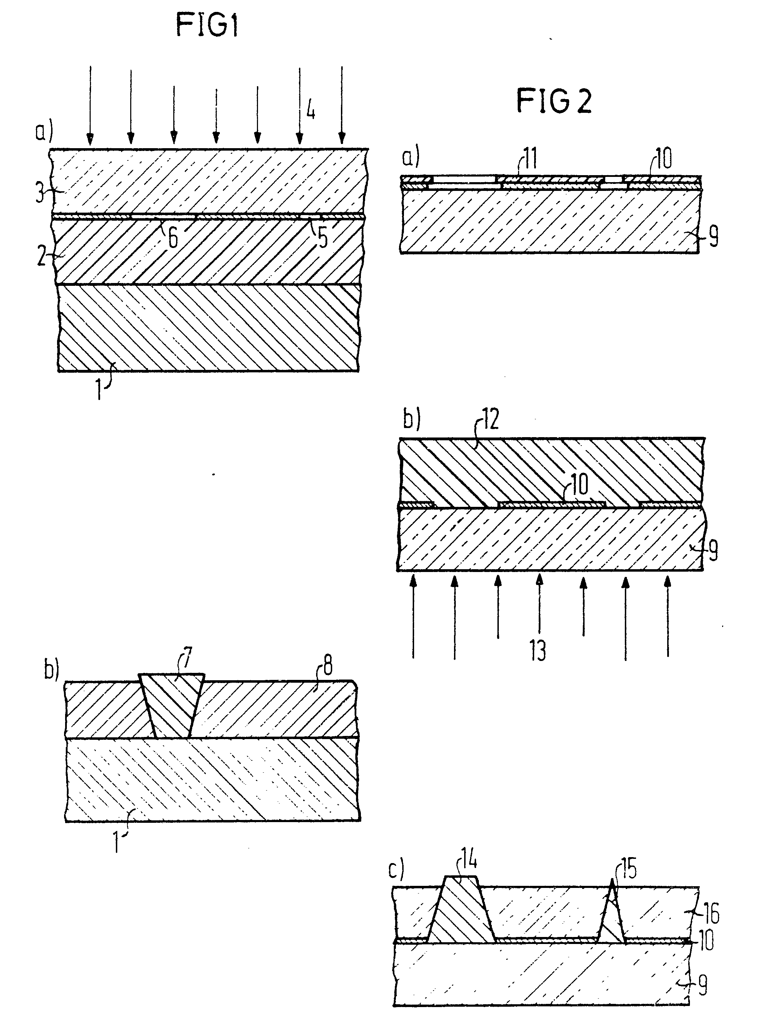

Die Arbeitsweise des konventionellen Galvanoplastikverfahrens, das in der Figur 1 angedeutet ist, gestattet es bei weitem nicht, das Auflösevermögen der Fotoresists wirklich zu nutzen.

In der US—A 3 900 359 ist ein Verfahren zur Herstellung von Schattenmasken für Farbfernsehbildröhren beschrieben, bei dem auf einem gewölbten Glaskörper eine perforierte dünne Metallisierung aufgebracht ist, über der sich ein Negativ-Photoresist befindet, der durch den Glaskörper mit der dünnen Metallisierung als Maske belichtet wird. Nach der Entwicklung des Fotoresists ist damit eine Matrize erstellt, von der auf dem Wege der galvanischen Abscheidung die Schattenmasken reproduziert werden können.

In der FR—A—2 356 975 ist ein fotolithographisches Verfahren beschrieben. Bei sämtlichen Ausführungsformen handelt es sich immer wieder nur um ein Rotieren des Lichtstrahles mit konstantem Neigungswinkel um ein- und dieselbe Drehachse — nämlich senkrecht zur Substratfläche. In dieser Patentschrift ist die Verwendung unterschiedlicher Lichtquellen nicht erwähnt.

Der Erfindung liegt die Aufgabe zugrunde, mit möglichst einfachen Mitteln das eingangs beschriebene Elektroplattier-Verfahren zu realisieren und die Resistauflösung zu steigern. Diese Aufgabe wird unter Anwendung des Verfahrens gelöst, bei dem

a) ein planer, voll lichtdurchlässiger Träger mit einer im Vergleich zum Träger dünnen, einseitigen Metallisierung versehen wird,

b) in der Metallisierung ein gewünschtes Muster erzeugt wird,

c) auf die das Muster enthaltende Metallisierung eine Negativ-Photoresistschicht aufgebracht wird,

d) die Negativ-Photoresistschicht durch den Träger und somit auch durch die das Muster enthaltende Metallisierung als Schablone (Maske) belichtet wird,

e) die belichtete Negativ-Photoresistschicht entwickelt wird und

f) die nicht mit Negativ-Photoresist bedeckten Bildteile über der Metallschablone durch galvanische Metallabscheidung ausgefüllt werden,

auf die Herstellung von Präzisionsflachteilen mit kleinsten Konturendetails bei großer Materialstärke, bei dem mit einer der gewünschten Flankenform der Konturen angepaßten Lichteinstrahlung durch den Träger belichtet wird.

Das Belichten des Resists beim herkömmlichen Verfahren durch eine Maske, die über Träger und Resist aufgelegt wird, ist bei dem Verfahren nach der Erfindung ersetzt von einer Belichtung durch den Glasträger, so daß nur an den nicht von der Schablone abgedeckten Flächen Licht in das Resist gelangt. Der Träger ist gleichzeitig Belichtungsmaske.

Durch diese Belichtungsweise wird nahezu das theoretische Optimum der Resistauflösung erreicht. Definiert man die Resistauflösung als Verhältnis von Resiststärke zur maximal möglichen Strukturfeinheit, so erhöht sich die Resistauflösung auf das Mehrfache. Ein Grund dafür ist, daß zwischen Maske (=Träger) und Resist vollkommener Kontakt vorliegt. Demgegenüber verbleibt bei dem bekannten Verfahren zwischen der Maske, die nicht vollkommen plan ist, und dem Resist immer noch ein geringer Luftspalt. Außerdem besteht bei den bevorzugt verwendeten Trockenresists eine Distanz zwischen Maske und Resist, die durch die obligatorische Schutzfolie auf dem Trockenresist bedingt ist.

Außerdem erhält bei dem Verfahren nach der Erfindung die Struktur an ihrer Basis die volle Lichtintensität. Sie hat dadurch ein maximales Haftvermögen. Die konventionelle Belichtung ergibt hingegen Unterbelichtung am Träger, also mit zunehmender Resisthöhe abnehmende Haftung. Unterbelichtung bewirkt außerdem eine Verjüngung der Resiststruktur und damit zusätzlich Basisverkleinerung am Träger. Darüber hinaus tritt bei dem erfindungsgemäßen Verfahren minimale Lichtreflektion beim Austritt aus dem Resist auf, wenn man eine mattschwarze Unterlage verwendet und zusätzlich bei Trockenresists die Schutzfolie vor dem Belichten abzieht. Beim konventionellen Verfahren mindert die Reflektion am metallischen Träger die Auflösung erheblich.

Für viele Flachteile werden geneigte Kanten gefordert (Düsenöffnungen, Beschichtungsmasken mit Aushebeschräge usw.). Es ist bekannt, daß die Neigung von Resistflanken durch Ausführung der Lichtquelle, Resiststärke und Resistart geringfügig beeinflußt werden kann, jedoch verjüngt sich die Negativ-Resiststruktur, die heute für Stärken ab etwa 10 $\mu$m allein in Frage kommt, stets auf die der Lichtquelle abgewandte Seite zu und verliert dadurch an Standfestigkeit. Beim Verfahren nach der Erfindung können im Gegensatz zum herkömmlichen Verfahren die Flanken beliebig geneigt sein, denn die Basis bleibt unverändert. Im Extremfall sind Kefelformen mit gut ausgebildeter Spitze möglich.

Nach einer Weiterbildung des Verfahrens werden durch zwei- oder mehrmaliges Belichten des Resists mit unterschiedlichen Lichtquellen Flanken mit — im Querschnitt gesehen — unstetigem Verlauf erzeugt. Dies kann für bestimmte Lochformen im Flacheil, z. B. für Düsenöffnungen, erwünscht sein.

Nach einer weiteren Ausgestaltung der Erfindung werden beim Belichten durch ein- oder mehrmaliges definiertes Neigen des Substrats gegen das einfallende Licht entsprechend geneigte Resiststrukturen erzeugt. Auf diese Weise ist es gezielt möglich, Flachteile mit geneigten Kanten herzustellen. Ebenso können durch Kontinuierliches Verändern der Substratneigung beim Belichten um eine oder mehrere Drehachsen senkrecht zum einfallenden Licht Resiststrukturen erzeugt werden.

Durch definiertes Neigen des Substrates (Trägers) gegen das einfallende Licht sowie gleichförmiges Drehen um eine Achse senkrecht zum Substrat beim Belichten entstehen rotationssymmetrische Strukturen mit definiert zum Substrat geneigten Mantellinien. Für Düsenöffnungen oder Schablonen (Aushebeschrägen) sind definiert geneigte Konturen erwünscht, die mit dem Verfahren nach der Erfindung leicht erzeugbar sind.

Nach einer Weiterbildung der Erfindung ist es möglich, auf eine mit Subsratneigung belichtete, aber nicht entwickelte Resistschicht weiter Resist zu laminieren und mit einem kleineren Neigungswinkel noch einmal zu belichten. Auf diese Weise entsteht eine Überlagerung zweier rotationssymmetrischer Drehkörper mit verschiedener Neigung der Mantelflächen.

Bei einer aus Grob- und Feinmaske zusammengesetzten Galvanoplastik besteht die Möglichkeit, daß man den Resist zur Erzeugung der Grobmaske durch den Glasträger belichtet, wobei die Feinmaske als Belichtungsmaske dient. Die bekannten Verfahren, eine Grob- und Feinmaske einander durch optisches Ausrichten zuzuordnen, erfordern eine beträchtlichen Aufwand und ergeben häufig Ungenauigkeiten. Das wird durch die Erfindung behoben; Lagefehler sind ausgeschlossen.

Die Weiterbildung der Erfindung besteht für relativ starke Flachteile darin, daß zweiseitig belichtet wird, und zwar einmal durch die Schablone, und das zweite Mal auf herkömmliche Weise durch eine aufgelegte Maske. Die Maske wird in diesem Fall auf den Resist aufgelegt und über ein Registriersystem (z. B. Anschläge) zur Schablone ausgerichtet. Man verwendet z. B. die gleiche Maske, die zur Erzeugung der Schablone (mit Positivresist) verwendet wird.

Die geringe Größe von Präzisionsflachteilen gegenüber dem Substrat ermöglicht häufig eine Mehrfachanordnung (Nutzen) der Teile. Dabei müssen alle Teile untereinander elektrisch leitend, also durch Stege verbunden sein, die bereits in der Schablone vorgesehen sind.

Als Plattierungsmaterial finden Metalle Verwendung, die vom Schablonenmaterial leicht zu trennen sind. Bei günstiger Kombination von Trägermetallisierung und Plattierungsmaterial kann die Galvanoplastik abgezogen werden, ohne daß die Schablone verletzt wird. Auch durch Belegen der Schablone mit einer dünnen Trennschicht kann das Abziehen des Galvanos ermöglicht werden. Auf diese Weise wird erreicht, daß sich eine Schablone mehrmals verwenden läßt.

Eine weitere Ausgestaltung des erfindungsgemäßen Verfahrens zur Erzeugung von Resiststrukturen besteht darin, daß nach dem Entwickeln der Negativ-fotoresistschicht die Metallschablone zwischen der verbleibenden Fotoresiststruktur entfernt wird. Solche Strukturen werden insbesondere bei der integrierten Optik gebraucht.

Die Erfindung wird anhand der Figur 2 erläutert.

Figur 1 zeigt ein konventionelles Verfahren und

Figur 2 das erfindungsgemäße Verfahren.

Auf einem metallischen Träger 1 ist in der Figur 1 ein Negativ-Fotoresist 2 aufgetragen. Diese Fotoschicht wird mit einer Belichtungsmaske 3 abgedeckt und der UV-Bestrahlung 4 eines Kopiergerätes ausgesetzt. Das durch die transparenten Flecke 5, 6 einfallende Licht löst in den darunterliegenden Bereichen des Fotoresist Polymerisationsreaktionen aus, die ein latentes Bild schaffen. Die nicht belichteten Teile werden abgelöst, so daß lediglich Resistreste 7 (Figure 1b) in Form der gewünschten Konturenbegrenzung des Flachteiles auf der Trägerplatte 1 zurückbleiben. Aus der Figur 1b ist ferner zu erkennen, daß die Struktur 5 nicht mehr aufgelöst wurde. Auf die Oberfläche des Trägers 1 wird nach Entfernen der nicht belichteten Fotoresistschicht z. B. ein Nickelfilm 8 galvanisch abgeschieden.

Im Teil a der Figur 2 ist eine Trägerplatte 9 aus Glas mit einer Metallisierung 10 zu erkennen. Diese besteht z. B. aus einer Titanhaftschicht, auf der Kupfer aufgedampft ist. In der Metallisierung wird fotolithographisch und ätztechnisch das gewünschte Flachteilmuster erzeugt, das als Schablone dient. Durch dünne Fotoresistschichten 11 erreicht man hohe Auflösung und damit hohe Qualität der Schablone. Die Schablone kann auch mit der bekannten Abhebetechnik hergestellt werden.

Im Teil b der Figur 2 ist die Fotoresistschicht 11 entfernt und auf der Schablone eine Fotofolie 12 als Resist aufgebracht. In diesem Fall erfolgt die Belichtung durch den Glasträger in Richtung der Pfeile 13. Aus Teil c der Figur 2 ist zu ersehen, daß beide Strukturen aufgelöst worden sind, entsprechende Resiststrukturen 14 und 15 sind stehengeblieben. Mit 16 ist die Plattierung bezeichnet. Auf diesen Verfahrensschritt kann das Ablösen der Galvanoplastik oder Auflösen der Trägers erfolgen.

Die zwischen der Resiststruktur liegenden Räume können anstatt durch Elektroplattieren auch durch Ausgießen z. B. mit Kunststoff ausgefüllt werden. Das entstandene Flachteil wird analog der Galvanoplastik vom Träger getrennt. Wird Material in Stärken größer als der Höhe der Resiststruktur aufgetragen, so können Platten mit Oberflächenreliefs erzeugt werden, wie man sie z. B. in der Drucktechnik benötigt.

## Patentansprüche

1. Anwendung des Verfahrens, bei dem

a) ein planer, voll lichtdurchlässiger Träger (9) mit einer im Vergleich zum Träger dünnen, einseitigen Metallisierung (10) versehen wird.

b) in der Metallisierung ein gewünschtes Muster erzeugt wird,

c) auf die das Muster enthaltende Metallisierung eine Negativ-Photoresistschicht (12) aufgebracht wird,

d) die Negativ-Photoresistschicht durch den Träger und somit auch durch die das Muster enthaltende Metallisierung als Schablone (Maske) belichtet wird.

e) die belichtete Negativ-Photoresistschicht entwickelt wird und

f) die nicht mit Negativ-Photoresist bedeckten Bildteile über der Metallschablone durch galvanische Metallabscheidung ausgefüllt werden,

auf die Herstellung von Präzisionsflachteilen mit kleinsten Konturendetails bei großer Materialstärke, bei dem mit einer der gewünschten Flankenform der Konturen angepaßten Lichteinstrahlung durch den Träger belichtet wird.

2. Anwendung des Verfahrens nach Anspruch 1, dadurch gekennzeichnet, daß durch zwei oder mehrmaliges Belichten der Negativ-Photoresistschicht (12) mit unterschiedlichen Lichtquellen Flanken mit — im Querschnitt gesehen — unstetigem Verlauf erzeugt werden.

3. Anwendung des Verfahrens nach Anspruch 1, dadurch gekennzeichnet, daß durch einoder mehrmaliges definiertes Neigen des Substrats gegen die Lichtrichtung beim Belichten entsprechend geneigte Resiststrukturen erzeugt werden.

4. Anwendung des Verfahrens nach Anspruch 1 und 3, dadurch gekennzeichnet, daß durch kontinuierliches Verändern der Substratneigung beim Belichten um eine oder mehrere Drehachsen senkrecht zum einfallenden Licht Resiststrukturen erzeugt werden.

5. Anwendung des Verfahrens nach Anspruch 1, dadurch gekennzeichnet, daß durch definiertes Neigen des Substrates gegen das einfallende Licht sowie gleichförmiges Drehen um eine Achse senkrecht zum Substrat beim Belichten rotationssymmetrische Strukturen mit definiert zum Substrat geneigten Mantellinien erzeugt werden.

6. Anwendung des Verfahrens nach Anspruch 5 auf eine belichtete, aber nicht entwickelte dadurch gekennzeichnet, daß Negativ-Photoresistschicht eine weitere Negativ-Photoresistschicht auflaminiert und mit einem kleineren Neigungswinkel noch einmal belichtet wird.

7. Anwendung des Verfahrens nach Anspruch 1 für relativ starke Flachteile, dadurch gekennzeichnet, daß zweiseitig belichtet wird, und zwar einmal durch die Metallschablone und eine zweites Mal auf herkömmliche Weise durch eine aufgelegte Maske von der Gegenseite der Negativ-Photoresistschicht her.

8. Anwendung des Verfahrens zur Erzeugung von Resiststrukturen nach den bisherigen Ansprüchen, dadurch gekennzeichnet, daß nach dem Entwickeln der Nagativ-Fotoresistschicht (12) die Metallschablone (10) zwischen der verbleibenden Fotoresiststruktur (14, 15) entfernt wird.

## Claims

1. The use for the production of flat precision components having the smallest contour details with a high material thickness of the process in which:—

a) a flat, completely light transmissive carrier (9) is provided with a metallisation (10) on one side only, which is thin in comparison with the carrier;

b) a desired pattern is produced in the metallisation;

c) a negative photo-resist layer (12) is applied to the metallisation containing the pattern;

d) the negative photo-resist layer is exposed to light through the carrier and thus also through the metallisation which contains the pattern which serves as a template (mask);

e) the exposed negative photo-resist layer is developed; and

f) the image portions above the metal template which are not covered by negative photo-resist layer, are filled up by electrolytic metal deposition; the exposure to light taking place through the carrier using light radiation which is matched to the desired flank form of the contours.

2. The use of the process as claimed in Claim 1, characterised in that flanks the course of which (considered in cross-section) is variable, are produced by double or multiple exposure to light of the negative photo-resist layer (12) using different light sources.

3. The use of the process as claimed in Claim 1, characterised in that by means of a single definite inclination of the substrate towards the direction of the light during exposure, or of a plurality of such definite inclinations, correspondingly inclined resist structures are produced.

4. The use of the process as claimed in Claims 1 and 3, characterised in that resist structures are produced by continually changing the inclination of the substrate during exposure to light about one or more axes of rotation at right angles to the incident light.

5. The use of the process as claimed in Claim 1, characterised in that by a definite inclination of the substrate in relation to the incident light and by uniform rotation about an axis at right angles to the substrate during the exposure to light, rotationally-symmetrical structures are produced having directrices which are inclined in a defined manner with respect to the substrate.

6. The use of the process as claimed in Claim 5, characterised in that a further negative photo-resist layer is laminated onto a negative photo-resist layer which has been exposed to light but which has not yet been developed, and is subjected to a further exposure using a smaller angle of inclination.

7. The use of the process as claimed in Claim 1 for relatively thick surface components characterised in that a double-sided exposure is effected, on the one hand, through the metal template and on a second occasion in conventional manner through an applied mask from the opposite side of the negative photo-resist layer.

8. The use of the process for the production of resist structures in accordance with the preceding Claims, characterised in that, after the development of the negative photo-resist layer (12), the metal template (10) is removed from between the remaining photo-resist structure (14, 15).

**Revendications**

1. Mise en oeuvre du procédé dans lequel:

a) un support plan (9) entièrement transparent à la lumière, est pourvu sur un côté, d'une métallisation (10) mince comparativement au support,

b) on réalise dans la métallisation un modèle souhaité,

c) on dépose sur la métallisation contenant le modèle une couche d'un photoresist négatif (12),

d) on éclaire la couche de photoresist négatif à travers le support et de ce fait également à travers la métallisation contenant le modèle, en l'utilisant comme patron (masque),

e) on développe la couche de photoresist négatif exposée, et

f) on comble les éléments d'image qui ne sont pas couverts par le photoresist négatif, au-dessus du patron métallique, par un dépôt métallique opéré par voie galvanique, pour la fabrication d'éléments plats de précision à mini-détails des contours et à forte épaisseur de matière, dans lesquels l'éclairage ou l'exposition a lieu à travers le support au moyen d'une radiation incidente adaptée aux contours de la forme des flancs.

2. Mise en oeuvre du procédé selon la revendication 1, caractérisée par le fait qu'à l'aide d'une exposition double ou multiple de la couche de photoresist négatif (12) à l'aide de deux sources différentes, on produit des flancs d'allure variable — si l'on regarde dans le sens de la section transversale.

3. Mise en oeuvre du procédé selon la revendication 1, caractérisée par le fait que par une inclinaison déterminée simple ou multiple du substrat par rapport à la direction de la lumière, on produit, par l'exposition, des structures de resist inclinées de façon correspondante.

4. Mise en oeuvre du procédé selon la revendication 1 et 3, caractérisée par le fait que par une modification continue de l'inclinaison du substrat lors de l'exposition, autour d'un ou de plusieurs axes de rotation, on produit, perpendiculairement à la lumière incidente, des structures de resist.

5. Mise en oeuvre du procédé selon la revendication 1, caractérisée par le fait que par une inclinaison déterminée du substrat par rapport à la lumière incidente, ainsi que par rotation uniforme autour d'un axe perpendiculaire au substrat, on produit, lors de l'exposition, des structures à symétrie de rotation présentant des génératrices inclinées de façon déterminée par rapport au substrat.

6. Mise en oeuvre du procédé selon la revendication 5, caractérisée par le fait que sur une couche de photoresist négatif exposée mais non développée, on dépose par laminage une autre couche de photoresist négatif et que l'on procède à une nouvelle exposition avec un angle d'inclinaison plus faible.

7. Mise en oeuvre du procédé selon la revendication 1 pour des objets plats relativement épais, caractérisée par le fait que l'on procède à une exposition double face notamment une fois à travers le patron métallique et une seconde fois de manière habituelle à travers un masque appliqué et à partir du côté opposé de la couche de photoresist négatif.

8. Mise en oeuvre du procédé pour la production de structures en photoresist selon l'une des revendications antérieures, caractérisée par le fait qu'après le développement de la couche de photoresist négatif (12), le patron métallique (10) situé entre la structure photoresist subsistante (14, 15) est enlevé.

FIG 1

FIG 2